# EUROPÄISCHE PATENTSCHRIFT

(11) **EP 0 298 237 B1**
(45) Veröffentlichungstag und Bekanntmachung des Hinweises auf die Patenterteilung: **26.01.1994**
(21) Anmeldenummer: 88108285.3
(22) Anmeldetag: 25.05.1988
(51) Int. Cl.: H01S 3/25, H01S 3/085, H01S 3/025, G08B 13/18

(54) **Lichtschranke**
Light barrier
Barrière lumineuse

(30) Priorität: 13.06.1987 DE 3719868
(43) Veröffentlichungstag der Anmeldung: 11.01.1989
(73) Patentinhaber: Deutsche Aerospace AG, 81663 München (DE)
(72) Erfinder: Spies, Hans, D-8068 Pfaffenhofen (DE); Wöhrl, Alfons, D-8898 Schrobenhausen (DE)

(56) Entgegenhaltungen:
- FR-A- 1 462 818
- FR-A- 2 598 263
- US-A- 3 518 574
- US-A- 4 660 275
- PATENT ABSTRACTS OF JAPAN, Band 9, Nr. 123 (E-317)[1846], 28. Mai 1985;& JP-A-60 10 687
- PATENT ABSTRACTS OF JAPAN, Band 9, Nr. 123 (E-317)[1846], 28. Mai 1985;& JP-A-60 10 686

## Beschreibung

Die Erfindung bezieht sich auf eine Lichtschranke mit Laserdioden aus Halbleitermaterial zur Überwachung von Räumen oder dergleichen.

Es ist bekannt, Laserdioden als Lichtquelle für Lichtschranken zur Überwachung von Räumen oder dgl. zu verwenden; vgl. "Bauelemente der Optik", H. Naumann, G. Schräder, Carl Hanser Verlag, München, Wien, 1983, S. 550 - 559. Laserdioden sind klein, billig und verbrauchen nur wenig Energie.

Der Erfindung liegt die Aufgabe Zugrunde, eine Lichtschranke für eine erweiterte Anwendung anzugeben.

Gemäß der Erfindung wird als Lichtquelle eine Laser-Doppeldiode aus zwei Einzeldioden verwendet, die zu beiden Seiten ihres Resonanzraumes als lichtdurchlässige Austrittsfenster dienende spiegelnde Flächen aufweisen, die etwa gleich lichtdurchlässig sind, so daß der Transmissionsgrad der beiden Austrittsfenster jeweils etwa 50 % beträgt und die einzelnen Lichtwege durch Lichtsrahlen etwa gleicher Intensität gebildet werden. Auf jeder Seite der Laser-Doppeldiode ist eine Optik und ein Umlenkspiegel vorgesehen, so daß sich zu beiden Seiten der Laser-Doppeldiode zwei versetzte parallele Lichtstrahlen ergeben. Die beiden Einzeldioden der Doppeldiode werden bevorzugt aus einem einzigen Halbleitersubstrat hergestellt, wie dieses im Prinzip aus der US-A- 4 660 275 bekannt ist, wobei jedoch gemäß Anspruch 2 der Trennschnitt so gelegt wird, daß die Lichtstrahlen der Dioden parallel sind.

Die Erfindung ist in einem Ausführungsbeispiel anhand der Zeichnung näher erläutert. In dieser stellen dar:
- Fig.1: eine Schematische Darstellung einer Laser-Doppeldiode gemäß der Erfindung für eine doppelte Lichtschranke;
- Fig. 2: eine Schematische Ansicht der aus zwei einzelnen Laserdioden bestehenden Doppeldiode für die Lichtschranke gemäß Fig. 1;
- Fig. 3: eine Schematische Darstellung einer bekannten Laserdiode.

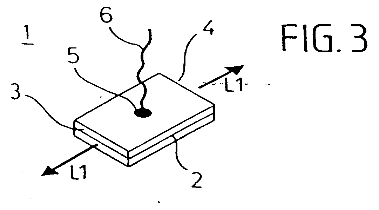

In Figur 3 ist eine Laserdiode 1 mit rechteckiger Grundfläche dargestellt, die nach einem herkömmlichen Verfahren hergestellt ist. Als Material wird z.B Galliumarsenid mit einem Brechungsindex von ungefähr 2,7 gewählt. Der Resonanzraum bzw. die Resonanzzone ist mit 2 dargestellt. Zu beiden Seiten des Resonanzraumes 2 ist dieser mit halbdurchlässigen Spiegeln 3 bzw. 4 versehen, deren Transmissionsgrad jeweils bei etwa 50 % liegt. Auf der Oberfläche der Laserdiode 1 ist ein Stromanschluß 5 angedeutet, dem über Anschlußdrähte 6 Strom zum Zünden der Laserdiode zugeführt Wird. Die Laserdiode arbeitet z.B. im Impulsbetrieb. Bei diesem Impulsbetrieb treten zu beiden Seiten durch die halbdurchlässigen Fenster 3 und 4 durch Pfeile L1 und L2 angedeutete Lichtstrahlen aus.

Die Lichtaustrittsfenster 3 und 4 können mit einer dünnen Siliziumdioxidschicht beschichtet sein, wodurch die Lichtausbeute noch gesteigert werden kann.

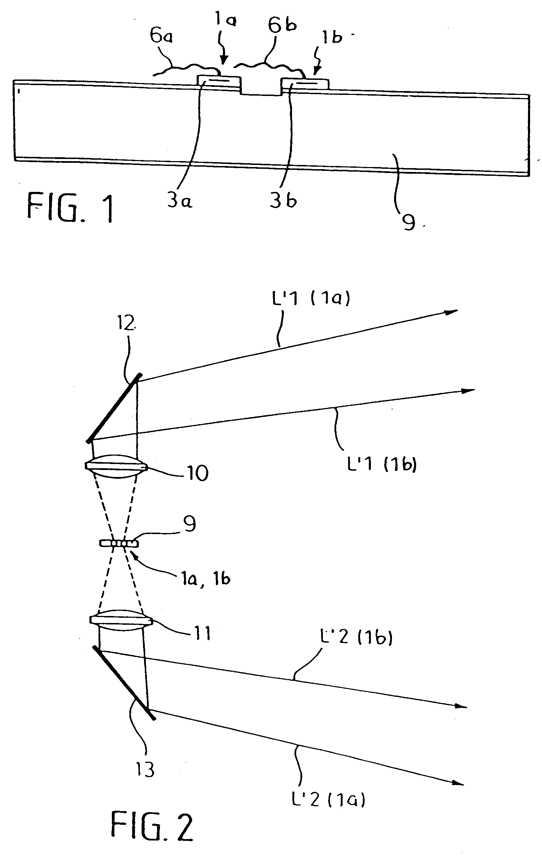

In Figur 1 ist eine Lichtschranke mit zwei Laserdioden 1a und 1b mit rechteckigen Querschnitt entsprechend der Diode in Figur 3 dargestellt. Die vorderen halbdurchlässigen Spiegel sind mit 3a und 3b bezeichnet. Für die Herstellung der beiden Laserdioden 1a und 1b wird aus einem Halbleitersubstrat in herkömmlicher Technik zunächst eine Einzeldiode gefertigt und auf einen Träger 9 in Form eines Balkens aufmontiert, z.B. aufgeklebt. Anschließend wird das Halbleitersubstrat z.B. mit einer Diamantsäge geteilt, so daß die beiden einzelnen Laserdioden la und 1b entstehen. Diese Art der Herstellung und der Montage auf einem Träger hat den Vorteil, daß dadurch die beiden Halbleiterdioden exakt zueinander ausgerichtet sind, d.h. parallele Lichtstrahlen abgeben. Die Anschlußdrähte für die Laserdioden sind mit 6a und 6b bezeichnet (Fig. 2).

Eine solche Lichtschranke kann zur Überwachung z.B. eines Raumes herangezogen werden. Zwischen zwei Optiken 10 und 11 ist der Balken 9 mit den beiden Dioden 1a und 1b angeordnet, so daß bei Ansteuerung der beiden Laserdioden durch beide Optiken 10 und 11 Licht auf Spiegel 12 bzw. 13 fällt und von diesen umgelenkt wird. Durch die versetzte Lage der beiden Laserdioden 1a und 1b auf dem Balken sind auch die Lichtstrahlen der beiden Dioden unterschiedlich. Der erste und zweite Lichtstrahl der Diode 1a ist in der Figur 1 mit L'1 (1a) bzw. L'2 (1a) bezeichnet, wohingegen der erste und zweite Lichtstrahl der Diode 1b mit L'1 (1b) bzw. L'2 (1b) bezeichnet ist. Die Lichtstrahlen der ersten Diode la liegen hierbei im Raume außen. Eine solche Einrichtung kann als doppelte Lichtschranke bezeichnet werden.

## Patentansprüche

1. Lichtschranke zur Überwachung von Räumen oder dergleichen, mit einer Laser-Doppeldiode aus Halbleitermaterial aus zwei einzelnen Laserdioden (1a, 1b) mit zueinander parallelen Lichtstrahlen, die zur Erzeugung von Laserresonanz zu beiden Seiten eines Resonanzraumes (2) als Austrittsfenster dienende spiegelnde Flächen (3,4) aufweisen, die beide etwa gleich lichtdurchlässig sind, wobei zu beiden Seiten der Laser-Doppeldiode je eine Optik (10,11) und anschließend an die Optiken (10,11) je ein Umlenkspiegel (12,13) vorgesehen ist.

2. Verfahren zur Herstellung einer Laserdiode zur Verwendung in einer Lichtschranke nach Anspruch 1, **dadurch gekennzeichnet,** daß die Laser-Doppeldiode (1a, 1b) aus einem Halbleitersubstrat gefertigt und nach Aufbringen auf einen Träger (9) durch einen Trennschnitt zu den zwei Laserdioden (1a, 1b) derart separiert wird, daß die Lichtstrahlen der Dioden (1a, 1b) parallel sind.

## Claims

1. Light barrier for monitoring rooms or the like, comprising a laser double diode of semi-conductor material of two individual laser diodes (1a, 1b) with parallel lightbeams, which for the purpose of producing a laser resonance have on both sides of a resonance area (2) reflective surfaces (3, 4) serving as outlet windows, which are both of approximately equal light permeability, and that on both sides of the laser double diode is provided a repective optic (10, 11) and adjacent to the optics (10,11) one each deflecting mirror (12, 13).

2. Process of manufacturing a laser diode for use in a light barrier according to claim 1, **characterised in that** the laser double diode (1a, 1b) is made of a semi-conductor substrate and is, after application onto a carrier (9), separated by a separating cut to the two laser diodes (1a, 1b) in such a manner that the lightbeams of the diodes (1a, 1b) are parallel to one another.

## Revendications

1. Barrage photoélectrique pour la surveillance de locaux ou analogues, avec une diode laser double à semi-conducteur constituée de deux diodes laser (1a, 1b) indépendantes avec des faisceaux lumineux mutuellement parallèles qui, pour produire une résonance laser présentent comme fenêtre de sortie, de part et d'autre d'une chambre de résonance (2), des surfaces réfléchissantes (3, 4) ayant la même transparence à la lumière, barrage photoélectrique dans lequel il est prévu de chaque côté de la diode laser double respectivement une optique (10, 11) et à la suite des optiques (10, 11) un miroir de déviation (12, 13).

2. Procédé de fabrication d'une diode laser destinée à être utilisée dans un barrage photoélectrique selon la revendication 1, caractérisé par le fait que la diode laser (1a, 1b) double est fabriquée à partir d'un substrat semi-conducteur et, après montage sur un support (9) est séparée par un trait de coupe pour former les deux diodes laser (1a, 1b), de manière telle que les faisceaux lumineux des diodes (1a, 1b) soient parallèles.
